# FASCICULE DE BREVET EUROPEEN

(11) **EP 1 949 771 B1**
(45) Date de publication et mention de la délivrance du brevet: **13.05.2009**
(21) Numéro de dépôt: 06831001.0
(22) Date de dépôt: 24.10.2006
(51) Int. Cl.: H05K 3/02, H05K 3/24, C25D 5/00, C25D 5/08, C25D 7/06, H01Q 1/38, H01Q 3/46, H05K 1/09, H05K 3/00, H05K 3/12

(54) **PROCÉDÉ POUR LA RÉALISATION D'UN CIRCUIT IMPRIMÉ À SURFACE NON DÉVELOPPABLE ET CIRCUIT IMPRIMÉ AINSI OBTENU**
VERFAHREN ZUR HERSTELLUNG EINER LEITERPLATTE MIT NICHT ENTWICKELBARER OBERFLÄCHE UND DADURCH HERGESTELLTE LEITERPLATTE
METHOD FOR PRODUCING A NON-DEVELOPABLE SURFACE PRINTED CIRCUIT AND THE THUS OBTAINED PRINTED CIRCUIT

(30) Priorité: 14.11.2005 FR 0511502
(43) Date de publication de la demande: 30.07.2008
(73) Titulaire: ASTRIUM SAS, 75016 Paris (FR)
(72) Inventeur: DESAGULIER, Christian, F-75016 PARIS (FR)
(74) Mandataire: Bonnetat, Christian
(86) Numéro de dépôt international: PCT/FR2006/002385
(87) Numéro de publication internationale: WO 2007/057528

(56) Documents cités:
- EP-A1- 0 551 780
- EP-A1- 1 120 856
- DE-A1- 4 010 244
- JP-A- 1 005 095
- US-A1- 2004 247 842
- PATENT ABSTRACTS OF JAPAN vol. 014, no. 342 (C-0743), 24 juillet 1990 (1990-07-24) & JP 02 125900 A (KAWASAKI STEEL CORP), 14 mai 1990 (1990-05-14)

## Description

La présente invention concerne un procédé pour la réalisation d'un circuit imprimé pourvu de motifs électriquement conducteurs sur une surface non développable à trois dimensions de son substrat isolant. Quoique non exclusivement, elle est particulièrement appropriée à la réalisation, sur une surface au moins approximativement en forme de paraboloïde, d'hyperboloïde, etc ... d'une grille de polarisation (antenne à réutilisation de fréquence) ou d'une série de motifs résonnants (antennes dichroïques), L'invention concerne également un circuit imprimé obtenu par la mise en oeuvre de ce procédé.

Pour réaliser des circuits imprimés précis, directement sur des surfaces à trois dimensions non développables, on peut mettre en oeuvre le procédé décrit dans les documents US-4 738 746 ; EP-0 241 331 et FR-2 596 230. Dans ce procédé, on commence par recouvrir uniformément ladite surface, alors non développable à trois dimensions, d'une couche d'une matière électriquement conductrice, que l'on recouvre à son tour d'une couche d'une matière de protection. Après formation desdites couches de matière conductrice et de matière de protection, on trace mécaniquement sur celles-ci le contour desdits motifs au moyen d'un outil creusant des sillons dont la profondeur est au moins égale à l'épaisseur de ladite couche de protection, puis on soumet lesdites couches à l'action d'un agent chimique susceptible d'attaquer sélectivement ladite matière électriquement conductrice sans attaquer ladite matière de protection, cette opération d'attaque chimique étant poursuivie pendant un temps suffisant pour que ladite matière électriquement conductrice soit éliminée sur toute son épaisseur à l'aplomb desdits sillons, après quoi on sépare du substrat, par pelage, les parties de ladite couche de matière électriquement conductrice extérieures auxdits motifs.

Ainsi, grâce à ce dernier procédé, on peut réaliser directement des motifs électriquement conducteurs sur des surfaces non développables à trois dimensions sans avoir recours à un masque ou un substrat auxiliaire avec lesquels, d'ailleurs, il serait techniquement difficile d'obtenir des motifs aussi précis tant au niveau de leur forme que de leur position sur lesdites surfaces.

Dans un tel procédé antérieur, pour le traçage des contours desdits motifs électriquement conducteurs, on utilise un outil pourvu d'au moins une pointe de gravure ou d'au moins une lame coupante, ledit outil étant monté dans une machine (par exemple à commande numérique et à cinq axes de rotation) chargée de le déplacer relativement à la surface non développable.

On peut ainsi réaliser des dispositifs à surface non développable portant des motifs électriquement conducteurs, de façon aisée et précise. Par exemple, la mise en oeuvre de ce procédé connu permet la réalisation de réflecteurs à grille de grande qualité, aptes à travailler dans la bande Ku (de 11 à 18 GHz) et formés d'au moins un réseau de fils conducteurs parallèles, ces fils conducteurs ayant une largeur de 0,25 mm, une épaisseur de 35 micromètres et étant répartis au pas de 1 mm sur une surface au moins approximativement en forme de paraboloïde, dont le diamètre d'ouverture peut atteindre 2300 mm.

Cependant, ce procédé antérieur présente des limites d'ordre technique et économique. Par exemple, si à la place d'un réflecteur à grille destiné à travailler dans la bande Ku, on désire réaliser un tel réflecteur destiné à la bande Ka (de 20 à 30 GHz), la largeur, l'épaisseur et le pas de répartition des fils conducteurs deviennent plus faibles (par exemple respectivement 0,125 mm, 18 micromètres et 0,5 mm) et il en résulte des difficultés dues à la plus faible largeur et à la plus faible épaisseur des fils conducteurs et des zones entre fils :
- les paramètres de traçage des motifs conducteurs (pression et disposition des pointes ou des lames de gravure) et les paramètres d'attaque chimique (durée) deviennent plus sensibles, de sorte qu'il en résulte des défauts géométriques et une fragilisation des fils conducteurs lors du pelage ;
- lors du traçage des fils conducteurs, les effets de bords deviennent significatifs, les pointes ou les lames repoussant, à la manière d'un soc, la matière conductrice d'épaisseur réduite et diminuant l'adhérence des fils conducteurs sur le substrat ; et
- les zones entre fils sont fragiles et sont donc susceptibles de se rompre lors du pelage.

II en résulte que l'on doit veiller à ce que l'outil exerce un traçage toujours parfait et que le déroulement du procédé doit être ralenti, ce qui accroît les coûts de fabrication d'un tel réflecteur.

Par ailleurs, par le document DE-40 10 244 A1, on connaît un procédé permettant de réaliser un circuit imprimé sur une surface non développable à trois dimensions. Dans ce procédé, on recouvre uniformément ladite surface d'une couche d'un vernis électriquement conducteur, puis on découpe au laser ladite couche à la forme du circuit imprimé. Enfin, on métallise l'ébauche de circuit imprimé ainsi obtenue, afin d'obtenir le circuit imprimé définitif.

Ainsi, le procédé décrit dans le document DE-40 10 244 A1 permet de réaliser les motifs des circuits imprimés sans avoir à découper mécaniquement par contact une couche de matière électriquement conductrice. Cependant, lors de l'ablation laser de la couche uniforme de vernis électriquement conducteur, on risque d'endommager ladite surface non développable.

La présente invention a pour objet de remédier aux inconvénients des procédés de la technique antérieure.

A cette fin, selon l'invention, le procédé pour la réalisation d'un circuit imprimé comportant des motifs électriquement conducteurs portés par une surface non développable à trois dimensions d'un substrat électriquement isolant, chaque motif électriquement conducteur comportant :
- une base reposant sur ladite surface non développable et réalisée en un vernis électriquement conducteur ; et
- un revêtement reposant sur ladite base et réalisé en un métal électriquement bon conducteur,
est remarquable en ce que lesdites bases sont réalisées par projection de jet dudit vernis sur ladite surface non développable au moyen d'une tête de projection mobile, semblable à une tête d'impression par jet d'encre.

Ainsi, grâce à la présente invention, il devient possible de réaliser lesdits motifs sans avoir à découper mécaniquement par contact ou par laser une couche de matière électriquement conductrice, ce qui élimine les inconvénients mentionnés ci-dessus. Lesdites bases des motifs peuvent être réalisées sur ladite surface non développable à l'aide d'une matière médiocrement conductrice, mais permettant de projeter aisément des ébauches desdits motifs, alors que ces ébauches sont ensuite utilisées pour former par voie électrolytique lesdits revêtements en un métal bon conducteur de l'électricité.

On peut ainsi réaliser des motifs de faibles dimensions, dont les bases et les revêtements présentent de faibles épaisseurs.

Bien que pouvant être médiocrement électriquement conductrice, la matière desdites bases (le vernis) doit permettre le dépôt électrolytique desdits revêtements. A cet effet, il est avantageux que sa résistivité soit inférieure à 30.10⁻⁶ Ω.cm, de préférence inférieure à 20.10⁻⁶ Ω.cm. La matière desdites bases peut être un vernis contenant des particules électriquement conductrices, par exemple des particules métalliques ou de carbone.

Pour déplacer ladite tête de projection par rapport à ladite surface non développable et former lesdites bases en correspondance avec lesdits motifs correspondants, on peut avantageusement utiliser une machine semblable à celle mentionnée ci-dessus, prévue pour la mise en oeuvre du procédé antérieur du document US-4 738 746.

Pour que ledit circuit imprimé selon l'invention puisse remplir sa fonction, la matière constitutive desdits revêtements doit être bonne conductrice de l'électricité ; par exemple, sa résistivité doit être inférieure à 3.10⁻⁶ Ω.cm, de préférence au plus égale à 2,5.10⁻⁶ Ω.cm. Cette matière peut être du cuivre, de l'or, etc ...

Dans le cas particulier où le circuit imprimé conforme à la présente invention est un réflecteur d'antenne travaillant à une fréquence d'au moins 20 GHz, l'épaisseur desdites bases peut être inférieure à 20 micromètres, alors que l'épaisseur desdits revêtements peut être au plus égale à 1 micromètre, par exemple 0,5 micromètre.

De préférence, lesdits revêtements électrolytiques sont déposés sélectivement au tampon sur lesdites bases.

Pour ce faire, on utilise un outil connu de dépôt électrolytique au tampon que l'on déplace, par rapport à ladite surface non développable, en restant au contact desdites bases. Là encore, pour déplacer ledit outil de dépôt, on peut avantageusement utiliser une machine semblable à celle mentionnée ci-dessus, prévue pour la mise en oeuvre du procédé antérieur du document US-4 738 746.

Les figures du dessin annexé feront bien comprendre comment l'invention peut être réalisée. Sur ces figures, des références identiques désignent des éléments semblables.
La figure 1 représente schématiquement un dispositif d'antenne, dont le réflecteur (représenté en coupe diamétrale) est pourvu de motifs électriquement conducteurs réalisés par la mise en oeuvre du procédé conforme à la présente invention.
La figure 2 est une vue de face schématique agrandie d'une partie du réflecteur de la figure 1, illustrant la forme et la disposition desdits motifs électriquement conducteurs.
Les figures 3A et 3B illustrent schématiquement, à l'aide de vues en coupe transversale par rapport à la figure 2, le procédé de réalisation du réflecteur d'antenne des figures 1 et 2.
La figure 4 illustre schématiquement l'étape du procédé de l'invention concernant le revêtement électrolytique sélectif au tampon des bases des motifs électriquement conductrices.

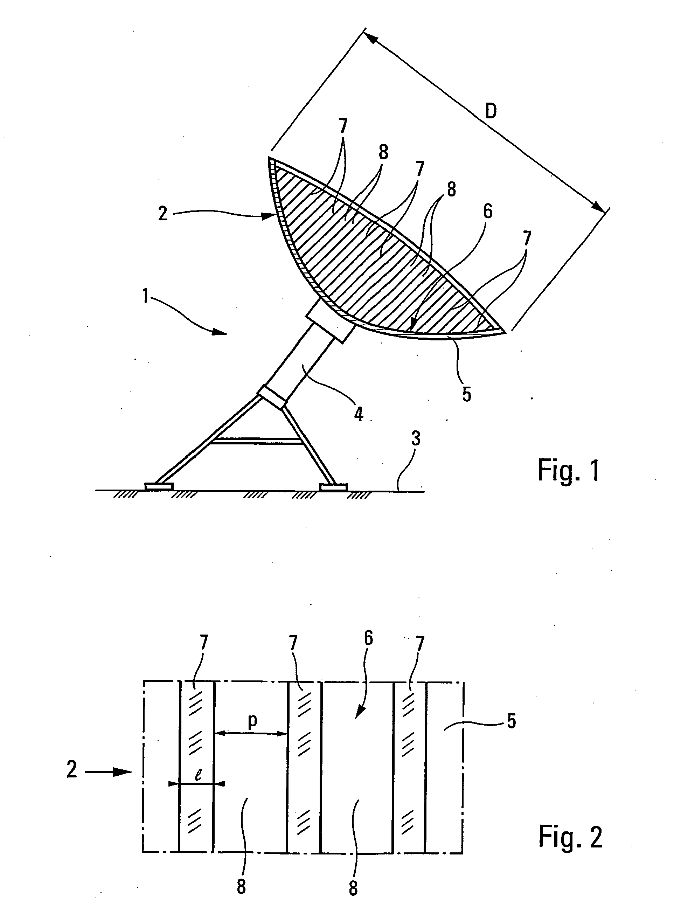

Sur les figures 2, 3A, 3B et 4, la surface du réflecteur portant les motifs électriquement conducteurs, bien que concave et non développable, est représentée plane pour des facilités de dessin.

Sur la figure 1, on a représenté schématiquement un dispositif d'antenne 1 pourvu d'un réflecteur d'antenne 2 (représenté en coupe diamétrale), supporté par une surface d'appui 3, par l'intermédiaire d'un support 4.

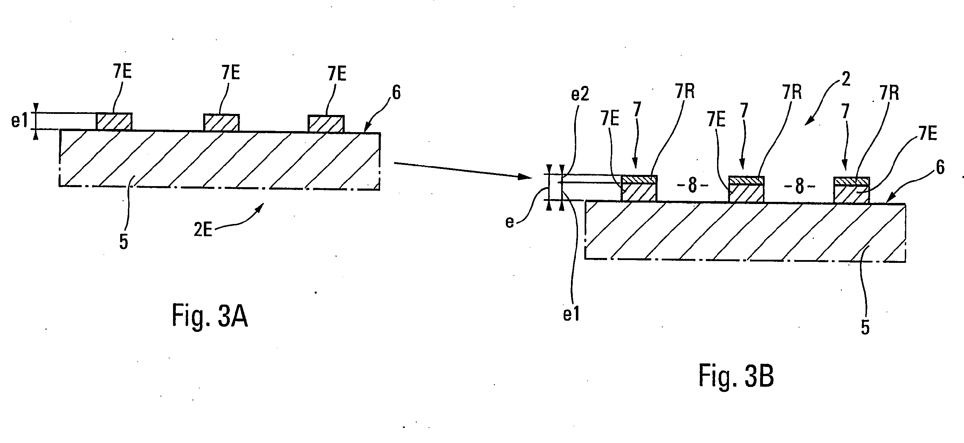

Le réflecteur 2 comporte un substrat électriquement isolant 5 (par exemple réalisé en matériau composite), dont la surface 6 opposée au support 4 est concave et présente une forme non développable, par exemple la forme au moins approximative d'un paraboloïde, d'un hyperboloïde, etc ... Sur cette surface 6 non développable à trois dimensions, le réflecteur 2 porte des motifs électriquement conducteurs, formés, dans l'exemple représenté, par des conducteurs 7 parallèles les uns aux autres et équidistants. Chaque conducteur 7 présente une section rectangulaire de largeur ℓ (de l'ordre de 0,1 mm) et d'épaisseur e (au plus égale à 20 micromètres) et le pas de répartition des conducteurs parallèles 7 est désigné par p (de l'ordre de 0,5 mm). Ainsi, entre deux conducteurs 7 adjacents est ménagée une zone de séparation 8, en forme de bande ayant une largeur égale à p (voir également les figures 2 et 3).

Le diamètre D de l'ouverture du réflecteur 2 peut être de l'ordre de 2300 mm.

Comme le montre la figure 3B, chaque conducteur 7 est composé d'une base 7E, reposant sur la surface non développable 6, et d'un revêtement 7R, reposant sur ladite base 7E. La base 7E présente une épaisseur e1 de l'ordre de 20 micromètres, alors que l'épaisseur e2 du revêtement 7R est au plus égale à 1 micromètre.

Pour réaliser le réflecteur 2, on procède tout d'abord à une étape préliminaire schématiquement illustrée sur la figure 3A. Selon cette étape préliminaire, on dépose sur la surface non développable 6 du substrat isolant 5, à l'aide d'une tête de projection mobile (non représentée) semblable à une tête d'impression par jet d'encre, un vernis électriquement conducteur (dont la résistivité est inférieure à 30.10⁻⁶ Ω.cm, par exemple inférieure à 20.10⁻⁶ Ω.cm) formant des ébauches des conducteurs 7, l'épaisseur desdites ébauches étant égale à e1. Lesdites ébauches sont destinées à former les bases 7E décrites ci-dessus.

A la fin de ladite étape préliminaire, on obtient donc une ébauche 2E du réflecteur, telle que représentée sur la figure 3A.

Ensuite, pour obtenir le réflecteur 2 à partir de l'ébauche 2E, on forme sur les bases 7E un dépôt électrolytique destiné à former les revêtements 7R (figure 3B).

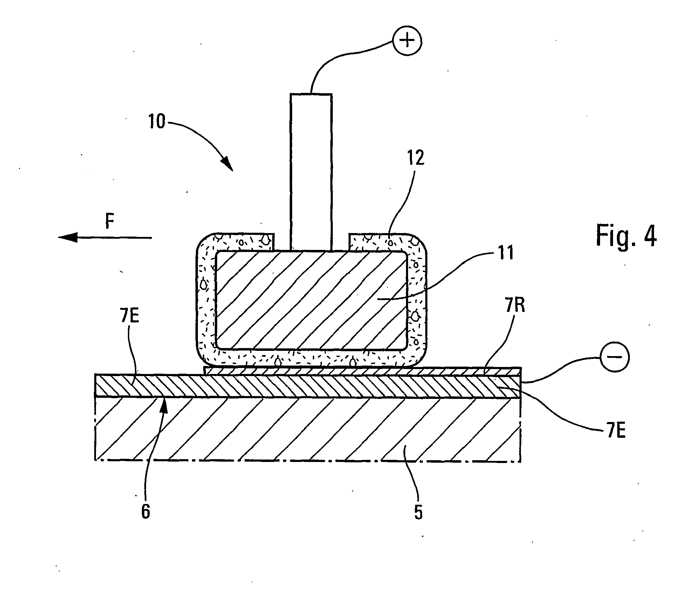

Pour ce faire, on met en oeuvre l'outil de dépôt sélectif au tampon 10, de type connu et représenté schématiquement sur la figure 4. L'outil 10 comporte un bloc 11, par exemple en graphite, recouvert d'une bonnette spongieuse 12. Le bloc 11 est relié à un pôle+ (ou à un pôle-) pour servir d'anode (ou de cathode), alors que la bonnette spongieuse 12 est imprégnée d'un électrolyte, apte à déposer le métal (par exemple cuivre, or, etc ...) que l'on désire pour former les revêtements 7R.

Comme représenté schématiquement sur la figure 4, pour revêtir une base 7E d'un revêtement 7R (et ainsi obtenir un conducteur 7), on relie ladite base 7E à un pôle- (ou à un pôle+) et on déplace (flèche F) l'outil 10 par rapport à ladite base 7E, la bonnette 12 étant au contact de cette dernière.

Ainsi, par électrolyse, l'électrolyte imprégnant la bonnette 12 dépose le revêtement 7R sur la base 7F.

De ce qui précède, on remarquera que la mise en oeuvre de la présente invention est :
- économique et rapide, notamment du fait que les vitesses d'impression par jet et d'électrolyse au tampon peuvent être très rapides (par exemple 0,1 m/s) et que l'on peut utiliser plusieurs têtes d'impression et plusieurs outils de dépôt électrolytique simultanément ;
- réversible, puisqu'une erreur de programmation de la machine ou une anomalie d'impression ou de dépôt électrolytique peut être corrigée, le processus pouvant reprendre après élimination de ladite anomalie, sans altération du substrat 5 ;
- robuste, puisqu'il s'affranchit de toute découpe mécanique de motifs très fins ; et
- versatile, puisqu'il permet la réalisation de motifs conducteurs de formes variées.

## Revendications

1. Procédé pour la réalisation d'un circuit imprimé (2) comportant des motifs électriquement conducteurs (7) portés par une surface non développable à trois dimensions (6) d'un substrat électriquement isolant (5), chaque motif électriquement conducteur (7) comportant :
- une base (7E) reposant sur ladite surface non développable (6) et réalisée en un vernis électriquement conducteur ; et
- un revêtement (7R) reposant sur ladite base (7E) et réalisé en un métal électriquement bon conducteur,
**caractérisé en ce que** lesdites bases (7E) sont réalisées par projection de jet dudit vernis sur ladite surface non développable (6) au moyen d'une tête de projection mobile, semblable à une tête d'impression par jet d'encre.

2. Procédé selon la revendication 1, dans lequel lesdits revêtements (7R) sont réalisés sur lesdites bases (7E) par électrolyse,
**caractérisé en ce que** les revêtements électrolytique (7R) sont déposés sélectivement sur lesdites bases à l'aide d'un tampon mobile (10).

3. Procédé selon l'une des revendications 1 ou 2,
**caractérisé en ce que** la résistivité dudit vernis électriquement conducteur est inférieure à 30.10⁻⁶ Ω.cm.

4. Procédé selon l'une des revendications 1 à 3,
**caractérisé en ce que** la résistivité du métal constituant lesdits revêtements (7R) est inférieure à 3.10⁻⁶ Ω.cm.

5. Circuit imprimé obtenu par le procédé selon l'une des revendications 1 à 4, destiné à former un réflecteur d'antenne travaillant à une fréquence au moins égale à 20 GHz,
**caractérisé en ce que** l'épaisseur desdites bases (7E) est au plus égale à vingt micromètres.

6. Circuit imprimé selon la revendication 5,
**caractérisé en ce que** l'épaisseur desdits revêtements (7R) est au plus égale à un micromètre.

## Claims

1. A method for producing a printed circuit (2) comprising electrically conducting patterns (7) on a three-dimensional nondevelopable surface (6) of an electrically insulating substrate (5), each electrically conducting pattern (7) comprising:
- a base (7E) resting on said nondevelopable surface (6) and made of an electrically conductive lacquer; and
- a coating (7R) resting on said base (7E) and made of a metal that is a good electrical conductor,
**characterized in that** said bases (7E) are produced by spraying a jet of said lacquer onto said nondevelopable surface (6) by means of a movable spray head, similar to an ink-jet printing head.

2. The method as claimed in claim 1, in which said coatings (7R) are produced on said bases (7E) by electrolysis,
**characterized in that** the electrolytic coatings (7R) are deposited selectively on said bases using a moveable pad (10).

3. The method as claimed in either of claims 1 and 2, **characterized in that** the resistivity of said electrically conductive lacquer is less than 30 x 10⁻⁶ Ω.cm.

4. The method as claimed in one of claims 1 to 3, **characterized in that** the resistivity of the metal constituting said coatings (7R) is less than 3 x 10⁻⁶ Ω.cm.

5. A printed circuit obtained by the method as claimed in one of claims 1 to 4, intended to form an antenna reflector working at a frequency of at least 20 GHz,
**characterized in that** the thickness of said bases (7E) is at most 20 microns.

6. The printed circuit as claimed in claim 5,
**characterized in that** the thickness of said coatings (7R) is at most 1 micron.

## Patentansprüche

1. Verfahren zur Herstellung einer gedruckten Schaltung (2), umfassend elektrisch leitende Muster (7), die von einer nicht abwickelbaren dreidimensionalen Fläche (6) eines elektrisch isolierenden Substrats (5) getragen werden, wobei jedes elektrisch leitende Muster (7) umfasst:
- eine Grundschicht (7E), die auf der nicht abwickelbaren Fläche (6) ruht und aus einem elektrisch leitenden Lack gebildet ist; und
- eine Deckschicht (7R), die auf der Grundschicht (7E) ruht und aus einem elektrisch gut leitenden Metall gebildet ist,
**dadurch gekennzeichnet, dass** die Grundschichten (7E) gebildet werden, indem Strahlen des Lacks mittels eines beweglichen Spritzkopfs, der einem Tintenstrahldruckkopf ähnelt, auf die nicht abwickelbare Fläche (6) gespritzt werden.

2. Verfahren nach Anspruch 1, wobei die Deckschichten (7R) auf den Grundschichten (7E) durch Elektrolyse gebildet werden,
**dadurch gekennzeichnet, dass** die elektrolytischen Deckschichten (7R) mit Hilfe eines beweglichen Stempels (10) selektiv auf den Grundschichten abgelagert werden.

3. Verfahren nach einem der Ansprüche 1 oder 2,
**dadurch gekennzeichnet, dass** der spezifische elektrische Widerstand des elektrisch leitenden Lacks unter 30.10⁻⁶ Ω.cm beträgt.

4. Verfahren nach einem der Ansprüche 1 bis 3,
**dadurch gekennzeichnet, dass** der spezifische elektrische Widerstand des Metalls, das die Deckschichten (7R) bildet, unter 3.10⁻⁶ Ω.cm beträgt.

5. Gedruckte Schaltung, die durch das Verfahren nach einem der Ansprüche 1 bis 4 hergestellt wurde und dazu bestimmt ist, einen Antennenreflektor zu bilden, der mit einer Frequenz arbeitet, die mindestens gleich 20 GHz beträgt,
**dadurch gekennzeichnet, dass** die Dicke der Grundschichten (7E) höchstens gleich zwanzig Mikrometer ist.

6. Gedruckte Schaltung nach Anspruch 5,
**dadurch gekennzeichnet, dass** die Dicke der Deckschichten (7R) höchstens gleich ein Mikrometer ist.
